# EUROPEAN PATENT APPLICATION

(11) **EP 1 954 114 A1**
(43) Date of publication of application: **06.08.2008**
(21) Application number: 06020667.9
(22) Date of filing: 30.09.2006
(51) Int. Cl.: H05K 7/20, C09J 163/00, H01L 23/482, H05K 3/32

(54) **Use of an adhesive composition for die-attaching high power semiconductors**

(71) Applicant: Umicore AG & Co. KG, 63457 Hanau-Wolfgang (DE)
(72) Inventor: Thomas, Muriel, 63128 Dietzenbach (DE); Schaack, Klaus, 63785 Obernburg (DE)

(57) **Abstract**

The Directive 2002/95/EC of the European Parliament and of the Council promulgated that from 1^{st} July 2006 new electrical and electronic equipment must no longer contain lead. Accordingly, lead-free solder alloys for various electrical and electronic applications have been developed. But at present, lead in high melting temperature type solders, e.g. used for die-attach applications, are exempted from the directive due to lack of lead-free alternatives for these alloys. The present invention provides a lead-free die-attach composition for attaching high power semiconductor devices to printed circuit boards. The die-attach composition comprises a metal filled epoxy resin, wherein the metal is selected from a powder comprising copper and having spheroidal particles with less than half of the copper atoms in a surface layer being oxidized as measured by XPS.

## Description

The present invention provides a lead-free adhesive composition for use in die-attachment of high power semiconductors.

According to the Directive 2002/95/EC of the European Parliament and of the Council, from 1^{st} July 2006 new electrical and electronic equipment put on the market must no longer contain lead and other hazardous substances. This directive has led to the development of lead-free solder alloys for various electrical and electronic applications. But there still exist some exemptions from the directive. Among others, lead in high melting temperature type solders (i.e. lead-based alloys containing 85 % by weight or more lead) do not have to be replaced due to lack of lead-free alternatives for these alloys. This exemption has just recently been confirmed by the Commission Decision 2005/747/EC of 21^{st} October 2005.

Lead-based solder alloys containing more than 85 % by weight of lead are up to now needed for so-called high-temperature applications with average operating temperatures of more than 150 °C and peak processing temperatures up to 260 °C. One prominent example are die-attach applications for power semiconductors. In these applications, the lead-based solder alloys provide sufficient resistance to thermal fatigue when subjecting the semiconductor devices to thermal cycling. In addition, these solders provide sufficient thermal conductivity for dissipating the heat generated by the power semiconductors.

According to Philip Adamson in "Lead-free Packaging for Discrete Power Semiconductors", a paper presented at the 2002 JEDEC Conference in Apr/May 2002, many small power packages already use a lead-free die-attach in the form of Ag-filled epoxy resins. These Ag-filled epoxy resins are loaded with up to 70 % silver. Their use, however, has not yet been expanded to larger silicon sizes in larger power packages. According to Adamson, Ag-filled epoxies have been tested by temperature cycling on larger components such as TO220. These experimental components were temperature cycled between -40 and +125 °C. These test conditions comply with condition "G" as specified by the JEDEC Standard JESD22-A 104C of May 2005.

The JEDEC Standard does not recommend test conditions that exceed +125 °C for Pb/Sn solder compositions. Nevertheless, the harsh operating conditions of power semiconductor devices require that they withstand test conditions specified by test condition "H" of the JEDEC Standard and require temperature cycling between -55 and +150 °C.

Although Directive 2002/95/EC exempts lead in high melting temperature type solders from being replaced with a lead-free alternative from 1^{st} July 2006 on, it would be very beneficial for the environment to replace high lead containing solders with a lead-free alternative for die-attach applications as soon as possible.

It is the object of this invention to provide a lead-free adhesive composition for use in die-attach applications of power semiconductors which reliably withstands temperature cycling according to JEDEC test condition "H" for at least 1000 cycles with a soak time of 15 minutes for maximum and minimum temperatures and yields heat dissipation similar to the high lead containing solders presently in use.

This objective is achieved by the die-attach composition specified in the claims. In particular, the die-attach composition for use according to the invention comprises a one component adhesive and a metal powder as filler, wherein the one component adhesive is an epoxy resin and wherein the metal of the metal powder has a thermal conductivity of more than 250 W/(m K) and comprises copper, and the powder particles have a spheroidal shape.

In the context of this invention the term "one component adhesive" designates a one pot adhesive composition comprising the adhesive and a latent curing agent which may be activated by supplying energy such as heat or ultraviolet radiation. The adhesive may be an epoxy resin, preferably a bisphenol epoxy resin. The one component adhesive has a long shelf live and starts to cure only after supplying external energy.

The cured die-attach composition has to allow similar heat dissipation as the conventional high lead solders used for attaching high power semiconductor devices. Such high lead solder alloys are e.g. Pb88Sn10Ag2 with a thermal conductivity of 55 W/(m · K) and Pb92.5Sn5Ag2.5 with a thermal conductivity of 44 W/(m · K). It has been found that the cured die-attach composition complies with the need with respect to power dissipation from the power semiconductor as well as resistance to temperature cycling.

Thermal conductivity of the cured die-attach composition is a function of thermal conductivity of the filler material, thermal conductivity of the epoxy resin, the volume fraction of the filler material and of the thermal contact resistance between the filler and the epoxy resin.

The resulting thermal conductivity is of course mainly influenced by the filler which comprises copper. Thermal conductivity of pure copper is 400 W/(m · K), while the thermal conductivity of epoxy resin is as low as 0.3 W/(m · K). To guarantee a high thermal conductivity of the filler-epoxy composite thermal conductivity of the filler powder should be larger than 250, preferably larger than 300 and most preferred larger than 350 W/(m · K).

The thermal conductivity of the filler-epoxy composite is further dependent on the volume fraction of filler. In the following, the term filling degree will be used instead of volume fraction of filler. The filling degree is defined as the weight percentage of filler relative to the total weight of the composite. According to the invention the powder particles of the metal powder should have a spheroidal or spherical shape. Flake like powders give inferior results and moreover adhesives filled with flakes will block the syringe when using the die-attach composition in dispensing applications. In case of spheroidal filler particles the maximum volume fraction is obtained for a hexagonal close packing with a volume fraction of 74 %. This value translates into a maximum filling degree of 95 wt.-% for a copper powder as filler by using the density of copper (8.9 g/cm³) and of epoxy resin (approximately 1.2 g/cm³).

The mean particle size D₅₀ of the copper powder has no decisive influence on thermal fatigue resistance of the filler-epoxy composite. Good results have been obtained with filler powders having a mean particle diameter D₅₀ between 1 and 50 µm. More preferred are mean particle diameters between 1 and 30 µm and even more preferred are mean particle diameters between 1 and 5 µm.

At last, the resulting thermal conductivity of the filler-epoxy composite depends on the thermal contact resistance between the filler surface and the resin. Any impurity layer on the surface of the filler particles will increase the contact resistance. Therefore it is preferred to use filler powders with low surface impurities.

Due to its high thermal conductivity it is preferred to use metal powders comprising a high percentage of copper. Most preferred are copper powders with a purity of copper of more than 99.5 wt.-% and especially more than 99.9 wt.-%.

In case of copper powder, the most detrimental impurity on the surface of the powder particles is copper (II) oxide. The proportion of copper (II) oxide relative to metallic copper in a thin surface layer of approximately 5 nm thickness can be determined with XPS (X-Ray Photoelectron Spectroscopy). For that purpose the obtained XPS spectra are analyzed by curve fitting as is well known in the art. It has been found that good results with regard to thermal conductivity and thermal fatigue of the cured composite can be obtained if at most 50 % of the atoms in the surface layer analyzed by XPS are oxidized to CuO. Preferably the oxidized copper atoms should not exceed 30 %, more preferred not more than 10 %.

Relative to the thermal conductivity of metal powders the thermal conductivity of cured epoxy resin is very low. The main task of the epoxy resin is to provide good adhesion to the metal filler and to the semiconductor device and the substrate. Epoxy resins selected from the group consisting of bisphenol A epoxy resin and bisphenol F epoxy resin have proven to provide good adhesion to copper and nickel surfaces as well as to chips. Bisphenol A epoxy resin is most preferred.

The cured die-attach composition comprising the cured adhesive filled with the specified filler powder and having a bond-line thickness between 20 and 80 µm withstands the above mentioned test conditions for thermal fatigue and yields a similar heat dissipation as high-lead solders.

For preparing the die-attach composition, the metal powder is thoroughly mixed with the expoxy resin. The composition is packed in one unit and can be kept at room temperature before use.

In order to attach discrete high power semiconductors to printed circuit boards with the die-attach composition, the composition is applied to the printed circuit board, the semiconductor is placed onto the board and the die-attach composition is then cured at a temperature between 80 and 250 °C, preferably at a temperature between 130 and 180 °C.

When using copper as filler material it is preferred to avoid oxidation of the copper surfaces during storage by coating the copper powder with an oxidation preventing material. The coating material may be a fatty acid, preferably a saturated fatty acid, a polysiloxane or a phosphide compound. The fatty acids can be selected from oleic acid, myristic acid, palmitic acid, margaric acid, stearic acid and arachidic acid. The coating material is applied in an amount of from 0.1 to 1 wt.-% relative to the total weight of the coated copper powder. Most preferred are coating materials with slight hydrophilic properties, i.e. with little polar groups, so as to minimize attraction of water.

For standard die-attach applications the die-attach composition should contain 40 to 90 wt.-% of metal powder relative to the total weight of the composition. For dispensing applications, the composition should contain between 40 and 80 wt.-%, preferably between 60 and 80 wt.-%, of metal for avoiding blockage of the dispensing nozzle. In case of die-attachment by printing, the adhesive composition may contain between 40 and 90 wt.-% of metal powder relative to the total weight of the composition.

The following examples and figures are intended to help in further explaining the present invention. The figures show:
**Figure 1:** Test rig for measuring heat dissipation
**Figure 2:** Heat dissipation in dependence of bond line thickness after curing for die-attach compositions filled with various filling degrees of copper powder.

### Example:

Table 1 lists die-attach compositions comprising copper powder mixed with bisphenol A epoxy resin to form metal filled adhesive compositions at different filling degrees for temperature cycling tests and heat dissipation measurements.

**Table 1: properties of die-attach compositions**

| | Die-attach composition | | |
|---|---|---|---|
| Parmeter | Cu1 | Cu2 | Cu3 |
| Copper purity (without coating) | >99.9 % | >99.9 % | >99.9 % |
| particle size [µm] | 1.5 | 1.5 | 1.5 |
| particle shape | spheroidal | spheroidal | spheroidal |
| Coating of particle surface | 0.5 wt-% fatty acid | 0.5 wt-% fatty acid | 0.5 wt-% fatty acid |
| Degree of surface oxidation | < 10 % | < 10 % | < 10 % |
| Epoxy resin | Bisphenol A | Bisphenol A | Bisphenol A |
| Filling degree | 70 % | 75 % | 80 % |

The copper particles had spheroidal shape, a purity of more than 99.9 % and a thermal conductivity of more than 350 W/(m · K). The die-attach compositions designated as Cu1, Cu2, Cu3 comply with the requirements of the present invention whereas a commercial "High Thermal Conductivity Silver Filled Epoxy Paste" (Ag) was selected for comparison reasons. A conventional high lead solder paste Pb (Pb88Sn10Ag2) served as reference material.

### Measurement of heat dissipation:

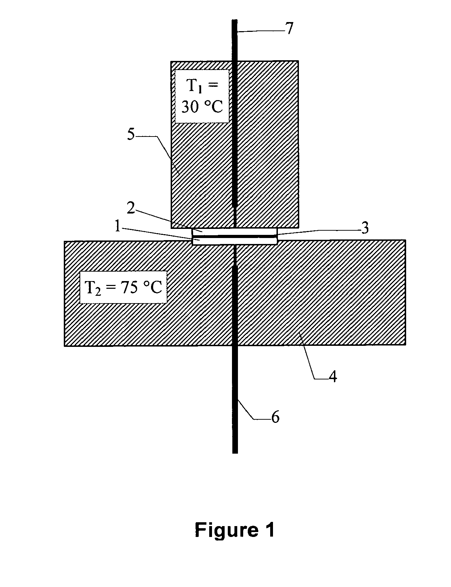

For measurement of heat dissipation versus bond line thickness a series of silicon chips were attached to copper substrates using the compositions of Table 1. The bond was cured for 30 minutes at 150 °C. The measurements were performed by using the test rig shown in Figure 1. The test pieces were placed with their copper substrates (1) on a copper block (4) heated to T₂ = 75 °C providing a constant temperature. The silicon chips (2) were contacted with another copper block (5) immersed in ambient air (T₁ = 30 °C). The temperatures at the copper and silicon side of the sandwiches were measured with thermocouples (6) and (7). The temperature difference ΔT between both sides is proportional to the heat dissipation of the test pieces consisting of silicon chip (2), bond line (3) and copper substrate (1).

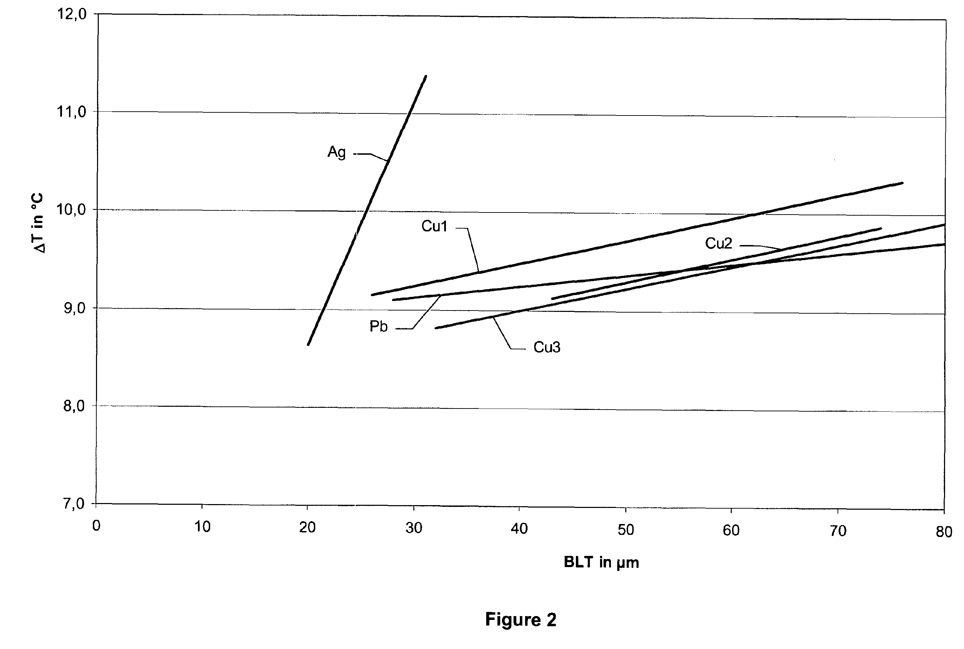

Figure 2 shows the temperature differences measured across the bond line of test pieces for different bond line thicknesses (BLT). The line designated with Pb shows the behavior of the reference sample attached with the commercial solder paste Pb. It can clearly be seen that the samples attached according to the invention with the die-attach compositions Cu1, Cu2 and Cu3 exhibit a similar thermal conductivity as the reference samples using soldering. Contrary, the comparison sample Ag shows a steep increase of the temperature difference with increasing bond line thickness and is thus not acceptable.

### Temperature cycling / Thermal fatigue

For the temperature cycling tests silicon chips of 12 x 12 x 0.5 mm³ were bonded to copper substrates with dimension 12 x 12 x 1 mm³ using the metal filled resins. The bond was cured for 30 minutes at 150 °C and resulted in a bond layer thickness of approximately 50 µm. The comparison die-attach compositions (Ag and Pb) were processed according to supplier's recommendations.

The test pieces were subjected to 1000 temperature cycles with 15 minutes soak time according to JEDEC Standard test condition "H" (-55 to +150 °C).

The die-attach compositions with metal powders Cu1 to Cu3 exhibited no failures after temperature cycling. Contrary to that, the conventional Ag/epoxy (Ag) did not pass the temperature cycling test. The results are shown in Table 2.

**Table 2: Thermal fatigue results after 1000 cycles (5 samples for each test)**

| Die-attach composition | | Filling degree of adhesive [wt.-%] | Test result |
|---|---|---|---|
| Metal Powder | Resin | | |
| Cu1 | bisphenol A | 70 | pass |
| Cu2 | bisphenol A | 75 | pass |
| Cu3 | bisphenol A | 80 | pass |
| Ag | unknown | 85 | fail |
| Pb | Solder paste | 100 | pass |

| | | | |
|---|---|---|---|
| pass: no delamination fail: chip is broken or delamination in the joint | | | |

## Claims

1. Use of a die-attach composition for attaching high-power semiconductor devices to a printed circuit board, wherein the die-attach composition comprises a one component adhesive and a metal powder and wherein the one component adhesive is an epoxy resin, and wherein the metal of the metal powder has a thermal conductivity of more than 250 W/(m · K) and comprises copper, and the powder particles have a spheroidal shape.

2. Use according to claim 1, wherein the metal powder has a mean particle diameter D₅₀ between 1 and 50 µm.

3. Use according to claim 2, wherein the metal of the metal powder is copper with a purity of more than 99.5 wt.-%.

4. Use according to claim 2, wherein the metal of the metal powder is copper with a purity of more than 99.9 wt.-%.

5. Use according to claim 3 or 4, wherein less than half of the copper atoms in a surface layer have been oxidized to CuO as measured by XPS.

6. Use according to claim 1, wherein the epoxy resin is selected from the group consisting of bisphenol A epoxy resin and bisphenol F epoxy resin.

7. Use according to claim 6, wherein the metal powder is pre-mixed with the epoxy resin.

8. Use according to claim 1, wherein the metal powder is coated with fatty acid, polysiloxane or with a phosphide compound prior to mixing with the components of the adhesive.

9. Use according to claim 1, wherein the die-attach composition is applied by dispensing and the composition contains 40 to 80 wt.-% of metal powder relative to the total weight of the composition.

10. Use of according to claim 1 wherein the die-attach composition is applied by printing and the composition contains 40 to 90 wt.-% of metal powder relative to the total weight of the composition.

11. Method for attaching discrete high power semiconductors to printed circuit boards by mixing the metal powder and the epoxy resin, applying the mixture to the power semiconductor or printed circuit board, placing the semiconductor onto the board and curing the die-attach composition at a temperature between 80 and 250 °C.

12. High power semiconductor device comprising a printed circuit board and attached thereon discrete high power semiconductors, wherein the high power semiconductors are attached to the printed circuit board with a cured die-attach composition as specified in claim 1 forming a bond line between the semiconductor and the printed circuit board with a thickness between 20 and 80 µm.
